# EUROPEAN PATENT SPECIFICATION

(11) **EP 2 130 056 B1**
(45) Date of publication and mention of the grant of the patent: **10.11.2010**
(21) Application number: 08734290.3
(22) Date of filing: 19.03.2008
(51) Int. Cl.: G01R 33/05

(54) **FLUXGATE SENSOR**
FLUXGATE-SENSOR
SONDE MAGNÉTOMÉTRIQUE A VANNE DE FLUX

(30) Priority: 23.03.2007 CZ 20070220
(43) Date of publication of application: 09.12.2009
(73) Proprietor: Ceské Vysoké Ucení Technické V Praze, 166 27 Praha (CZ)
(72) Inventor: RIPKA, Pavel, 181 00 Praha 8 (CZ); BUTTA, Mattia, I-238 51 Galbiate (lc) (IT)
(74) Representative: Duskova, Hana
(86) International application number: PCT/CZ2008/000031
(87) International publication number: WO 2008/116427

(56) References cited:
- US-A- 5 650 570
- US-A- 5 994 899
- RIPKA P ET AL: "Characterisation of magnetic wires for fluxgate cores" TRANSDUCERS '07 & EUROSENSORS XXI. 2007 14TH INTERNATIONAL CONFERENCE ON SOLID-STATE SENSORS, ACTUATORS AND MICROSYSTEMS IEEE PISCATAWAY, NJ, USA, 2007, pages 2410-2413, XP002493375 ISBN: 1-4244-0841-5

## Description

### Technology Field

The invention deals with a fluxgate sensor intended for accurate measurements of weak magnetic fields.

### Existing Conditions of Technology

Fluxgate sensors are used for measuring weak magnetic fields in geophysics, medical diagnostics, navigation and for contactless measurements of electric currents. Military implementation thereof is significant as well - e.g. when searching for unexploded ammunition and bombs, for detection of vehicles and guiding missiles. Most commonly used fluxgate sensors feature parallel orientation of magnetic fields. Sensors of this type usually have toroid core; oval (race-track) cores or wire-shaped cores are less common. These sensors are usually equipped with two coils: excitation coil and pick-off coil.

Main disadvantages of currently used fluxgate sensors with parallel orientation of magnetic fields include high consumption, large dimensions and high price.

Also, we know fluxgate sensors with orthogonal magnetic fields. The advantage of these sensors is that they may be excited by alternating current passing through ferromagnetic core. Core of these sensors is most commonly in shape of a wire, tube or thin layer. However, even these sensors must be equipped with pick-up coil.

The need to use at least one coil is one of the major disadvantages of fluxgate sensors. Miniaturization of such coils is rather complicated and miniature-sized fluxgate sensors for this reason do not show required parameters.

Devices similar to fluxgate sensors are GMI (Giant magnetoimpedance) sensors such as sensor described in US 5 944 899 A. The basic Property of fluxgate sensor is that the sensor core is Periodically saturated by the excitation current and that its output is on the second harmonic (or higher even harmonic) of the excitation frequency. Magnetoimpedance sensors have the output on the same frequency as the measuring current which serves as the excitation signal. The main disadvantage of GMI sensors is that the measured signal is at the same frequency as the excitation signal, therefore these two signals cannot be separated by frequency filter,

Some published magnetic sensors with functional ferromagnetic wire core use galvanic contacts instead of coils. These sensors include asymmetrical magneto-impedance sensor with helical anisotropy described in US 5 944 899 and also magnetic stress sensor described in US 5 650 570 A. However US 5 650 570 A cannot be used to directly measure magnetic field. When US 5 650 570 A is used to indirectly measure the magnetic field (e.g. by using magnetostrictive wire), the sensor output has very large temperature dependence.

Some fluxgate sensors already use magnetic wire cores as described in Ripka et al.: "Characteristic of magnetic wires for fluxgate cores" presented during 14^{th} International conference on solid-state sensors, actuators and microsystems. However up to now all these fluxgate sensors have one or more coils. The disadvantage is that the presence of coils forms an obstacle in miniaturization.

### Summary of the Invention

Disadvantages of known fluxgate sensors as mentioned above are eliminated by fluxgate sensor with ferromagnetic core equipped with electrically conductive first and second input current contacts, i.e. excitation contacts, according to the presented solution. Its principle is that such ferromagnetic core is directly equipped with first and second output voltage contacts.

Ferromagnetic core particularly suitable for this type of sensor is for instance a ferromagnetic core with helical anisotropy as described in US 5 994 899. Such anisotropy may be created in various ways, e.g. by annealing under torsional mechanical stress.

Advantageous embodiment is formed by ferromagnetic core in shape of thin magnetic layer on electrically conductive wire.

In this way, fluxgate sensor without coils is created, the core of which is made of ferromagnetic material and directly equipped with two electrically conductive output voltage contacts. Such ferromagnetic core is magnetized by passing of alternating excitation electric current and the output of this sensor is voltage on ferromagnetic core, most commonly the second harmonic of such voltage.

Advantage of this embodiment is that the sensor includes no coil. This design therefore allows for easy miniaturization and integration of the sensor.

### Overview of Figures in Drawings

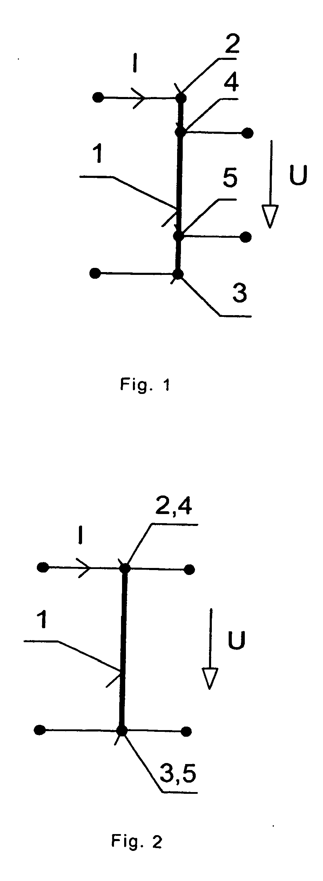

Example of fluxgate design of sensor without coils according to the presented invention is schematically shown in the attached drawing. Fig. 1 shows embodiment with two electrically conductive input current contacts and with two electrically conductive output voltage contacts and fig. 2 shows example where the input current and output voltage contacts are merged. The sensor has ferromagnetic core 1, through which passes the alternating current I. The output is most commonly the second harmonic of output voltage U.

### Detailed Description of the Preferred Embodiments

Ferromagnetic core 1 of the fluxgate sensor according to the example shown in fig. 1 has shape of a wire equipped on one its end with electrically conductive first input current contact 2 and on its other end with electrically conductive second input current contact 3, which are the excitation contacts. Ferromagnetic core 1 also contains other two electrically conductive contacts - first output voltage contact 4 and second output voltage contact 5. Embodiment in fig. 2 is similar, difference here is that the first input current contact 2 is merged with the first output voltage contact 4, which is marked by reference number 2,4 in fig. 2, and analogically the second input current contact 3 is merged with the second output voltage contact 5, which is marked by reference number 3,5 in fig. 2. Advantage of the embodiment shown in fig. 1 is that when the current and voltage contacts are separated, the influence of contact resistance is suppressed. If contacts are merged, voltage drop at this (often unstable) transition resistance is transferred to the sensor's output. Impact of instability of such transition resistance to the sensor's parameters may be negligible for many applications. In such cases the embodiment with two contacts shown in fig. 2 may offer more advantages for design. Alternating electrical current I passes through a wire forming the ferromagnetic core 1 and magnetizes it in circumferential direction until saturation. For proper function of the sensor it is vital that due design of excitation circuits ensures that this current consists only of odd harmonics of the basic excitation frequency f. Ferromagnetic core 1 shows voltage U drop caused by it electrical impedance. When external magnetic field is zero, this voltage contains only odd harmonic components of the basic excitation frequency f.

If the fluxgate sensor is exposed to axial direct magnetic field B, which is to be measured, voltage U begins to contain even harmonic components, especially the second harmonic will be present. Amplitude of such even harmonics is proportional to intensity of field B.

This relation is shown for example in case when the ferromagnetic core 1 has helical anisotropy. Helical anisotropy may be achieved by various methods. One possible method is for instance annealing of the ferromagnetic core 1 under torsional mechanical stress, annealing in magnetic field or application of mechanical stress or magnetic field directly during manufacturing process of the core.

Ferromagnetic core 1 may advantageously have the shape of thin magnetic layer on electrically conductive non-magnetic wire. Excitation current then passes completely or mostly through conductive non-magnetic wire and the magnetic layer on the surface is then evenly magnetized which results in higher linearity and limited remanent flux density (so-called Perming effect).

### Industrial Applicability

Fluxgate sensor without coils according to the presented solution may be used for instance for measurements of weak magnetic fields for navigation, localization of ferromagnetic objects or for contactless measurements of electric currents.

## Claims

1. Fluxgate sensor with ferromagnetic core (1), equipped with electrically conductive first and second input current contacts (2 and 3) and electrically conductive first and second output voltage contacts (4 and 5) and the ferromagnetic core (1) is a ferromagnetic core with helical anisotropy **characterized by the fact that** the ferromagnetic core (1) has a structure of thin magnetic layer on electrically conductive wire.

## Patentansprüche

1. Ferromagnetischer Fühler mit dem ferromagnetischen Kern (1), bestückt mit dem stromleitfähigen ersten und zweiten Eingangs-Stromkontakt (2 und 3), sowie mit dem stromleitfähigen ersten und zweiten Ausgangs-Spannungskontant (4 und 5), wo ferromagnetischer Kern (1) der ferromagnetische Kern mit der schraubenförmigen Anisotropie ist, **die sich damit auszeichnet, dass** dieser ferromagnetische Kern (1) Struktur einer dünnen magnetischen Schicht auf dem stromleitfähigen Draht aufweist.

## Revendications

1. Un capteur fluxgate formé autour d'un noyau magnétique (1) avec une première et deuxième connexion conductrices d'alimentation en courant (2 et 3) et une première et deuxième connexion conductrices sorties tension (4 et 5), où le noyau magnétique (1) soit un noyau magnétique anisotrope en structure hélice, le noyau **étant caractérisé par le fait que** ce noyeau magnétique (1) est constitué d'un fil conducteur recouvert d'une mince couche magnétique.
